# EUROPÄISCHE PATENTANMELDUNG

(11) **EP 0 780 693 A2**
(43) Veröffentlichungstag der Anmeldung: **25.06.1997**
(21) Anmeldenummer: 96250296.9
(22) Anmeldetag: 20.12.1996
(51) Int. Cl.: G01R 29/08

(54) **Verfahren und Vorrichtung zur Erzeugung und zum Empfang elektromagnetischer Wellen zu Prüfzwecken**

(30) Priorität: 21.12.1995 DE 19549246
(71) Anmelder: Euro EMC Service Dr. Hansen GmbH, 14513 Teltow (DE)
(72) Erfinder: Hansen, Diethard, Dr.-Ing., 8965 Berikon 2 (CH); Ristau, Detlef, Dr.-Ing.habil, 12435 Berlin (DE); Schreiber, Thomas, Dipl.-Ing., 12277 Berlin (DE); Roth, Eva, Dipl.-Ing., 12105 Berlin (DE)
(74) Vertreter: Hengelhaupt, Jürgen, Dipl.-Ing.

(57) **Zusammenfassung**

Die Erfindung beschreibt ein Verfahren und eine Vorrichtung zur Erzeugung und zum Empfang elektromagnetischer Wellen zu Prüfzwecken und ist anwendbar insbesondere für Messungen, Untersuchungen und Prüfungen zur elektromagnetischen Verträglichkeit.
Dabei wird zur Immunitätsprüfung der Prüfling mit definierten Feldparametern beaufschlagt und bei der Emissionsmessung die von dem Prüfling ausgesandte elektromagnetische Strahlung gemessen.
Wesentliches Merkmal der Erfindung ist, daß eine als TEM-Wellenleiter ausgebildete Zelle um den Prüfling herum gedreht wird.
Die Vorrichtung ist dadurch gekennzeichnet, daß der Deckel und der Boden der pyramidenförmigen Zelle elektrisch leitend ausgebildet ist und in geringem Abstand zu dem Deckel und dem Boden symmetrisch jeweils eine flächige Septe angeordnet ist, welche aus einzelnen Drähten gleicher Länge besteht.

## Beschreibung

Die Erfindung betrifft ein Verfahren und eine Vorrichtung zur Erzeugung und zum Empfang elektromagnetischer Wellen zu Prüfzwecken und ist anwendbar insbesondere für Messungen, Untersuchungen und Prüfungen zur elektromagnetischen Verträglichkeit. Es sind verschiedene Vorrichtungen zur sogenannten EMI-Prüfung (Electromagnetic-Interference) bekannt, welche auf sich pyramidenförmig aufweitenden TEM (transversalelektromagnetischen) Wellenleitern basieren.

So beschreibt die EP 0 246 544 eine Vorrichtung zur EMI-Prüfung elektronischer Geräte mit sich pyramidenförmig aufweitenden Metallwänden zur Erzeugung von TEM-Wellen, wobei der TEM-Wellenleiter durch eine Wand aus Hochfrequenz-Spitzenabsorbern abgeschlossen ist und einen asymmetrisch angeordneten, plattenförmigen Innenleiter aufweist, welcher durch die Absorberwand hindurch auf eine Anzahl von Abschlußwiderständen geführt ist.
Nachteilig an dieser Lösung ist, daß unerwünschte, örtliche und frequenzabhängige Inhomogenitäten des Wellenfeldes auftreten und der Prüfraum durch die Anordnung des plattenförmigen Innenleiters eingeschränkt ist.

Mit der EP 0 517 992 wurde eine Vorrichtung zur EMI-Messung bekannt, welche ein Septum, bestehend aus fünfzehn Drähten, die zunächst auf einem Bogen angeordnet sind und dann in eine parallele Führung übergehen, aufweist. Das Septum ist asymmetrisch in der Zelle angeordnet und das Feld eine ebene, vertikal polarisierte Welle. Der Abschluß erfolgt mit parallelen Widerständen hinter den Absorbern. Der Prüfling wird um die Y-Achse gedreht.
Nachteilig an dieser Lösung ist, daß der Prüfraum ebenfalls durch die Absorber und durch den großen Abstand des Septums zur Außenwand eingeschränkt ist. Durch die großen Abmessungen und das hohe Gewicht sind spezielle Aufstellräume für diese Vorrichtung erforderlich.

Der Erfindung liegt daher die Aufgabe zugrunde, ein Verfahren und eine Vorrichtung zu schaffen, mit welchen mit einfachen Mitteln zuverlässig und reproduzierbar homogene elektromagnetische Felder erzeugt bzw. empfangen werden können und die Zelle hinsichtlich ihrer Abmaße und ihres Gewichtes minimiert und deren Prüfraum maximiert werden kann.

Diese Aufgabe wird erfindungsgemäß gelöst durch die Merkmale im kennzeichnenden Teil der Ansprüche 1 und 8 in Verbindung mit den Merkmalen im jeweiligen Oberbegriff.
Zweckmäßige Ausgestaltungen der Erfindung sind in den Unteransprüchen enthalten.

Ein besonderer Vorteil der Erfindung besteht darin, daß es durch die Drehbewegung der Zelle um den Prüfling herum sehr einfach ist, polarisierte elektromagnetische Wellen zu erzeugen bzw. zu empfangen, die horizontal und vertikal als auch in allen anderen Positionen der XY-Ebene den Prüfling flächig durchdringen bzw. verlassen. Die Drehbewegung der Zelle kann dabei sowohl um die X-Achse als auch um die Y-Achse erfolgen. In Verbindung mit der 360°-Drehung des Drehtisches um die Y- bzw. die X-Achse wird die dritte Raumkoordinate in Z-Richtung erfaßt. Bei der Störmemissionsuntersuchung kann damit jede schmale Strahlkeule des Prüflings nachgewiesen werden. Die Messung kann automatisiert durchgeführt werden, so daß sich hierdurch große Meßzeiteinsparung ergibt.

Dadurch, daß der Deckel und der Boden der Zelle elektrisch leitend ausgebildet ist und in geringem Abstand zu dem Deckel und dem Boden symmetrisch jeweils ein flächiges Septum angeordnet ist, welches aus einzelnen Drähten gleicher Länge besteht, wird eine große Feldhomogenität erreicht.

Ein weiterer Vorteil der Erfindung resultiert daraus, daß der Abstand der Septen zu den leitenden Wänden aufgrund der geringeren Kapazität der Drähte im Vergleich zu einer festen Platte wesentlich geringer ist. Dieses in Verbindung mit dem Auskleiden der Wände mit flachen Ferritabsorbern erlaubt eine Verkleinerung der Außenmaße und des Gewichtes der Zelle bei gleichgroßem Prüfvolumen im Vergleich zu dem bekannten Stand der Technik.

Das Auskleiden der Seitenwände mit Ferritabsorbern dämpft die Mehrfachreflexionen an den Seitenwänden, wodurch die Verzerrungen des Feldes im Prüfvolumen verhindert werden.
Ein weiterer Vorteil der Drahtanordnung ist der Wegfall von Querströmen, die bei einer festen Platte entstehen und als Quelle eines elektromagnetischen Störfeldes auftreten.
Durch die senkrechte Anordnung der Abschlußwiderstände und den geringen Abstand des Septums zu der leitenden Wand wird ein optimal kurzer Abschluß des Drahtes mit seinem Wellenwiderstand erreicht. Das Auftreten der parasitären Induktivitäten wird damit vermieden und die Reflexionsfreiheit bis zu hohen Frequenzen erreicht. Durch die in einem Kreisbogen endenden Drahtanordnungen sind die elektrischen Laufwege und Laufzeiten der Wellen auf dem Innenleiter gleich.

Die Erfindung soll nachstehend anhand von in den Figuren teilweise dargestellten Ausführungsbeispielen näher beschrieben werden.
Es zeigen:
- Fig. 1: eine drehbar gelagerte Zelle für die Drehung um den Prüfling um die X-Achse herum;
- Fig. 2: eine Ansicht in das Innere der Zelle hinein;

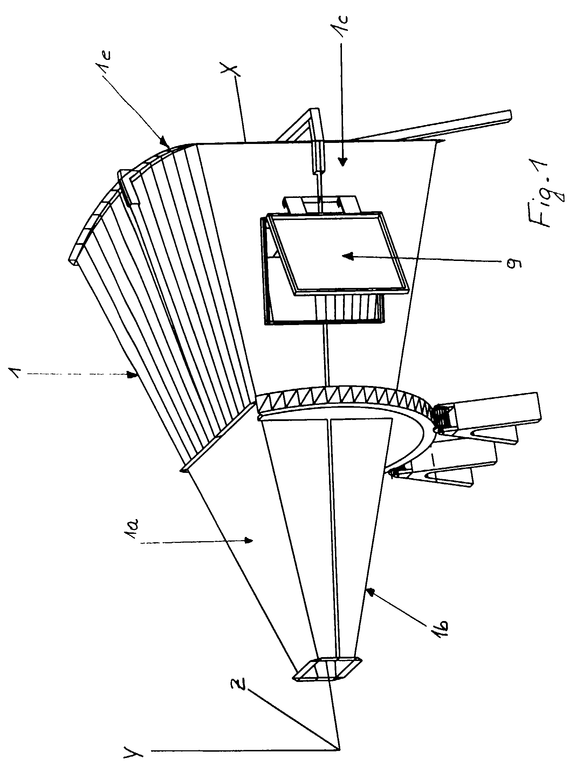

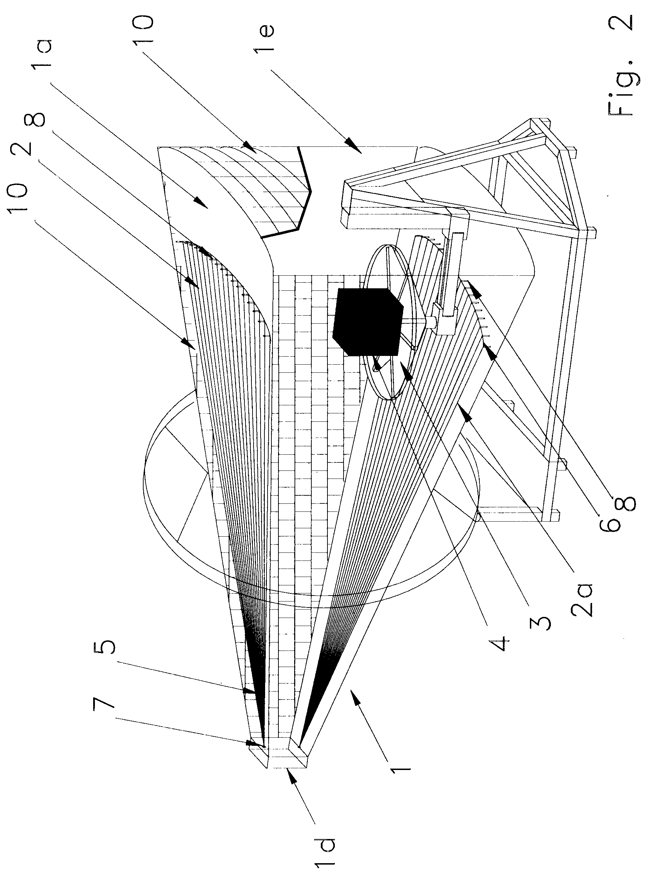

Wie aus den Fig. 1 und 2 zu entnehmen ist, ist die Zelle 1 eine metallische, seitensymmetrische Pyramide, gebildet aus Deckel 1a, Boden 1b, Seitenwänden 1c und Spitze 1d, die mit einer Rückwand 1e in Form eines Zylindersegmentes abgeschlossen ist. Die Rückwand 1e und die zwei kleineren Seitenwände 1c sind mit Ferritabsorbern 10 ausgekleidet. Die Ferritabsorber 10 sind im vorliegenden Ausführungsbeispiel als flache Kacheln ausgebildet. Der Deckel 1a und der Boden 1b der pyramidenförmigen Zelle 1 sind elektrisch leitend. Parallel zu den leitenden Wänden Deckel 1a und Boden 1b sind im geringen Abstand, im vorliegenden Ausführungsbeispiel 2,5 cm, zwei Septen 2 angebracht, die jeweils aus achtzehn Drähten 2a ..... 2₁₈ bestehen. Die Drähte 2a, .... 2₁₈ breiten sich strahlenförmig von der Spitze 1d der Zelle 1 fast bis zur Rückwand 1e aus. Die Drahtenden bilden einen Bogen 6, wodurch die Längen der Drähte 2a, .... 2₁₈ und damit die Laufzeit der Welle auf allen Drähten 2a, .... 2₁₈ gleich ist. Die Drähte 2a, .... 2₁₈ sind mit induktionsarmen Widerständen 8a, .... 8₁₈ abgeschlossen, welche senkrecht auf den Drähten 2a, .... 2₁₈ stehen und die Septen 2 mit dem Deckel 1a bzw. mit dem Boden 1b der Zelle 1 verbinden. Die einzelnen Widerstände 8a,...... 8₁₈ haben im vorliegenden Ausführungsbeispiel den Wert von 450 Ω und ergeben so in einer Parallelschaltung für jedes Septum 2 25 Ω. An der anderen Seite der Zelle 1 werden die Drähte 2a, .... 2₁₈ jeweils auf ein kurzes Blech 5 mit Zacken 5a,..... 5₁₈ geführt, welches an SMB-Buchsen 7 angeschlossen ist.

An den Eingang wird die elektromagnetische Energie aus einem in den Figuren nicht dargestellten CW-Generator über ein Symmetrieübertrager (Balun) an die Septen 2 zugeführt. Anstelle dieser Zuführung ist es ebenso möglich, zwei schnelle Hochspannungspulsgeneratoren so anzuschließen, daß eine Spannungsverdopplung zwischen den beiden Septen 2 auftritt. Hierdurch wird die frequenzbegrenzende Symmetrieübertragungseigenschaft des Baluns umgangen und gegebenenfalls bis zur Frequenz Null erweitert.
An mindestens einer der Seitenwände 1c befindet sich eine HF-dichte Tür 9, durch die ein Prüfling 4 auf einen Drehtisch 3 mit einer 360°-Drehbewegung um in diesem Ausführungsbeispiel die Y-Achse gestellt werden kann.

Die Zelle 1 ist gemäß diesem Ausführungsbeispiel auf zwei Untergestellen auf einer Höhe von ca. 1,4 m so angebracht, daß ein Drehen der Zelle 1 in der XY-Ebene um 360° möglich ist. Die Drehbewegung der Zelle 1 wird durch einen elektrischen Motor realisiert. Das Positionieren der Zelle 1 kann zweckmäßigerweise in Schritten von 1° erfolgen. Der Drehtisch 3 dreht sich mit der Zelle 1 nicht mit, sondern wird - unabhängig von der Bewegung der Zelle 1 - extern über einen gesonderten Motor angetrieben. Alle Motoren sind außerhalb der Zelle 1 angeordnet.

Die Funktionsweise der Zelle 1 soll nachfolgend sowohl für die Immunitäts- als auch die Emissionsmessung an einem Prüfling 4, der sich im Inneren der Zelle 1 befindet, beschrieben werden.

Der Meßbereich der Zelle 1 erstreckt sich dabei von größer 100 kHz bis in den Bereich größer 10 GHz, der CW-Generator besitzt eine typische Leistung von 100 W. Der Prüfling 4 wird auf einen Drehtisch 3 mittig zwischen den Septen 2 positioniert und mit einer Auflösung von 1° um die Y-Achse gedreht. Bei der Immunitätsmessung wird ein Signal CW-Generator an der Spitze 1d der Zelle 1 über einen Symmetrieübertrager eingespeist. Dieses Signal breitet sich als TEM-Welle auf den Septen 2 aus und erzeugt ein senkrechtes, elektrisches Feld zwischen den Septen 2. Die TEM-Welle hat zur Folge ein senkrecht aufeinanderstehendes E- und H-Feld, das den Fernfeldbedingungen entspricht. Das in der Zelle 1 erzeugte Feld ist in einer Richtung polarisiert. Um den Prüfling 4 von allen Seiten mit dem Feld zu beaufschlagen, muß die Polarisationsebene des Feldes geändert werden. Dies wird bei diesem Ausführungsbeispiel durch das Drehen der Zelle 1 in der XY-Ebene, also um die x-Achse um den Prüfling 4 herum erreicht. Die Z-Komponente der Raumkoordinaten wird durch das Drehen des Prüflings 4 überprüft.
Der mit diesem Prüffeld beaufschlagte Prüfling 4 wird auf die Veränderungen seines Betriebszustandes beobachtet. Bei der Emissionsmessung wird an der Spitze 1d der Zelle 1 ein in den Figuren ebenfalls nicht dargestellter Empfänger angeschlossen. Die Septen 2 dienen als Empfangsanordnung und leiten die eingefangene Störstrahlung des Prüflings 4 zum Empfänger hin. Um alle möglichen Störaussende-Ebenen zu erforschen und auch schmale Sendekeulen zu empfangen ist es zweckmäßig, die Drehbewegung der Zelle 1 und des Drehtisches 3 mit 1° Genauigkeit zu betreiben. Die Drehungen, der Empfang und die Einkopplung der Wellen wird vollautomatisch über den gesamten Meßbereich durchgeführt und die Werte mit dazugehörigen Grenzwerten im Protokoll festgehalten. Die Grenzwerte sind in sogenannten Freifeldmeßverfahren niedergelegt. Die Zellenmeßwerte werden entsprechend auf diese umgerechnet.

Die Erfindung ist nicht auf die hier beschriebenen Ausführungsbeispiele beschränkt. Vielmehr ist es möglich, durch Variation der Mittel und Merkmale weitere Ausführungsvarianten zu realisieren, ohne den Rahmen der Erfindung zu verlassen.

### Bezugszeichenliste

- 1: Zelle
- 1a: Deckel
- 1b: Boden
- 1c: Seitenwände
- 1d: Spitze
- 1e: Rückwand
- 2: Septum
- 2a bis 2n: Drähte
- 3: Drehtisch
- 4: Prüfling
- 5: Blech
- 5a bis 5n: Zacken
- 6: Bogen
- 7: SMB-Buchsen
- 8a bis 8n: Widerstände
- 9: HF-dichte Tür
- 10: Ferritabsorber

## Patentansprüche

1. Verfahren zur Erzeugung und zum Empfang elektromagnetischer Wellen zu Prüfzwecken mit in einer abgeschlossenen Zelle befindlichem Prüfling, wobei zur Störfestigkeitsprüfung der Prüfling mit definierten Parametern beaufschlagt wird und bei der Messung der Störaussendung die vom Prüfling ausgesandte elektromagnetische Strahlung gemessen wird,
dadurch gekennzeichnet,
daß die Zelle um den Prüfling herum gedreht wird.

2. Verfahren nach Anspruch 1,
dadurch gekennzeichnet,
daß die Drehung um die X-Achse herum erfolgt.

3. Verfahren nach Anspruch 1,
dadurch gekennzeichnet,
daß die Drehung um die Y-Achse herum erfolgt.

4. Verfahren nach Anspruch 1 oder 2,
dadurch gekennzeichnet,
daß der Prüfling zusätzlich auf einem Drehtisch angeordnet ist und um die Y-Achse rotiert und dabei die dritte Raumkoordinate in Z-Richtung überprüft bzw. erfaßt wird.

5. Verfahren nach Anspruch 1 oder 3,
dadurch gekennzeichnet,
daß der Prüfling zusätzlich auf einem Drehtisch angeordnet ist und um die X-Achse rotiert und dabei die dritte Raumkoordinate in Z-Richtung überprüft bzw. erfaßt wird.

6. Verfahren nach mindestens einem der voranstehenden Ansprüche,
dadurch gekennzeichnet,
daß die Drehung bzw. Rotation 360° beträgt.

7. Verfahren nach mindestens einem der voranstehenden Ansprüche,
dadurch gekennzeichnet,
daß die Drehung bzw. Rotation in 1°-Schritten erfolgt.

8. Vorrichtung zur Erzeugung und zum Empfang elektromagnetischer Wellen zu Prüfzwecken mit einer pyramidenförmigen Zelle als TEM-Wellenleiter und im Inneren der Zelle angeordneten Absorbern und Septen sowie einem Drehtisch zur Aufnahme des Prüflings,
dadurch gekennzeichnet,
daß der Deckel (1a) und der Boden (1b) der Zelle (1) elektrisch leitend ausgebildet ist und im geringen Abstand zu dem Deckel (1a) und dem Boden (1b) symmetrisch jeweils ein flächiges Septum (2) angeordnet ist, welches aus einzelnen Drähten (2a, .... 2n) gleicher Länge besteht und die Zelle (1) Mittel zur Erzeugung einer Drehbewegung der Zelle (1) um den auf einem Drehtisch (3) angeordneten Prüfling (4) herum aufweist.

9. Vorrichtung nach Anspruch 8,
dadurch gekennzeichnet,
daß die Drähte (2a, ..... 2n) strahlenförmig von der Spitze (1d) der Zelle (1) zur Rückwand (1e) verlaufen.

10. Vorrichtung nach Anspruch 9,
dadurch gekennzeichnet,
daß die Drähte (2a, ...... 2n) von einem Blech (5) mit Zacken (5a, .... 5n) ausgehen und einen Bogen (6) bildend kurz vor der Rückwand (1e) enden.

11. Vorrichtung nach Anspruch 10,
dadurch gekennzeichnet,
daß das Blech (5) an SMB-Buchsen (7) angeschlossen ist.

12. Vorrichtung nach mindestens einem der Ansprüche 8 bis 10,
dadurch gekennzeichnet,
daß die Drähte (2a, ..... 2n) mit induktionsarmen Widerständen (8a, ..... 8n) abgeschlossen werden.

13. Vorrichtung nach Anspruch 12,
dadurch gekennzeichnet,
daß die Widerstände (8a, ..... 8n) senkrecht auf den Drähten (2a, ... 2n) stehen und die Septen (2) mit dem Deckel (1a) bzw. dem Boden (2b) verbinden.

14. Vorrichtung nach Anspruch 1,
dadurch gekennzeichnet,
daß in mindestens einer der Seitenwände (1c) eine HF-dichte Tür (9) angeordnet ist.

15. Vorrichtung nach Anspruch 1,
dadurch gekennzeichnet,
daß die Rückwand (1e) und die Seitenwände (1c) mit Ferritabsorbern (10) ausgekleidet sind.

16. Vorrichtung nach Anspruch 15,
dadurch gekennzeichnet,
daß die Ferritabsorber (10) als flache Kacheln ausgebildet sind.

17. Vorrichtung nach Anspruch 8,
dadurch gekennzeichnet,
daß die Zelle (1) an der Spitze (1d) entweder durch einen impedanzangepaßten Symmetrieübertrager (Balun) oder zwei schnelle impedanzangepaßte Hochspannungspulsgeneratoren abgeschlossen ist.
